Europäisches Patentamt

European Patent Office

Office européen des brevets

(19)

(11) Veröffentlichungsnummer: **0 071 171**
**B1**

# (12) EUROPÄISCHE PATENTSCHRIFT

(45) Veröffentlichungstag der Patentschrift:
27.02.85

(21) Anmeldenummer: 82106569.5

(22) Anmeldetag: 21.07.82

(51) Int. Cl.⁴: **G 03 F 9/00**, B 65 H 3/12,
**G 03 G 15/00, G 03 B 27/60**

(54) **Saugvorrichtung.**

(30) Priorität: 29.07.81 DE 3129899
26.09.81 DE 3138404

(43) Veröffentlichungstag der Anmeldung:
09.02.83 Patentblatt 83/6

(45) Bekanntmachung des Hinweises auf die Patenterteilung:
27.02.85 Patentblatt 85/9

(84) Benannte Vertragsstaaten:
**BE DE FR GB IT NL**

(56) Entgegenhaltungen:
**CH - A - 566 570**
**DE - A - 2 213 532**

(73) Patentinhaber: **HOECHST AKTIENGESELLSCHAFT,**
**Postfach 80 03 20, D-6230 Frankfurt am Main 80 (DE)**

(72) Erfinder: **Schön, Klaus-Peter, Rathenauplatz 14,**
**D-6200 Wiesbaden (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft eine Saugvorrichtung zum Festhalten von Druckplatten in einer Bearbeitungsposition durch Unterdruck und zum Transport durch mehrere Bearbeitungsstationen.

Derartige Saugvorrichtungen werden in Druckplattenverarbeitungsanlagen eingesetzt, in denen die einzelne Druckplatte aus einem Plattenmagazin zu einer Belichtungsbühne transportiert wird, deren wesentlicher Bestandteil eine derartige Saugvorrichtung ist.

Bei der Herstellung von Druckplatten werden diese zuerst aufgeladen und anschliessend bildmässig mit einer Kopienvorlage belichtet. Hierzu ist es erforderlich, dass die Druckplatte in der Belichtungsstation möglichst plan aufliegt.

Aus der DE-B Nr. 1597858 ist ein elektrofotografisches Durchlaufkopiergerät für blattförmiges Aufzeichnungsmaterial bekannt, das eine Sauggreifeinrichtung zum Abheben des obersten Blattes von einem Stapel und zum Zuführen des Blattes zu einer Transportvorrichtung aufweist. Diese besteht aus einem Transportwagen, an dessen Unterseite eine Unterdrucksaugeinrichtung zum Halten des Aufzeichnungsmaterials vorgesehen ist.

Bei diesem bekannten Durchlaufgerät ist es zeitraubend, dass eine von der Transportvorrichtung getrennte Saugeinrichtung das Aufzeichnungsmaterial von dem Stapel abhebt und an die Unterdrucksaugeinrichtung des Transportwagens übergibt, und anschliessend dieser das Aufzeichnungsmaterial zu der Aufladungseinrichtung und den dahinter in Reihe angeordneten Bearbeitungsstationen weitertransportiert.

Aus der US-Patentschrift Nr. 3330555 ist ein elektrofotografisches Kopiergerät bekannt, bei dem die Kopienblätter zu einer Vakuumansaugplatte geführt werden.

Bei dem aus der DE-C Nr. 2462216 bekannten Gerät zur Druckplattenverarbeitung entnimmt ein Transportwagen, der an der Unterseite eine Vakuumplatte aufweist, die oberste Druckplatte aus einem Plattenmagazin. Der Transportwagen wird in Richtung Belichtungsbühne verfahren, und sobald er eine Position oberhalb der Belichtungsbühne erreicht hat, wird er auf diese abgesenkt und der Unterdruck der Vakuumplatte aufgehoben, so dass die Druckplatte freigegeben und auf die Belichtungsbühne abgesetzt wird. Die Belichtungsbühne ist gleichfalls mit einer Vakuumplatte ausgerüstet, die mit Unterdruck beaufschlagt wird, sobald die Druckplatte auf ihr aufliegt. Dadurch wird die Druckplatte für den Belichtungsvorgang fest auf die Belichtungsbühne gepresst. Dabei zeigt es sich, dass die im allgemeinen aus auf Rollen gewickelten Aluminiumbahnen hergestellten, vorsensibilisierten Druckplatten eine ungenügende Planlage besitzen, wodurch das vollständige Ansaugen der Druckplatte auf die Vakuumplatte der Belichtungs- oder einer Entwicklungsstation unzureichend ist, was Anlass zu Unschärfen bei der Belichtung bzw. der Entwicklung geben kann. Die ungenügende Planlage der Druckplatten kommt durch das Aufwickeln der Aluminiumbahnen auf Kernen zustande, da dadurch in dem Materialgefüge elastische Verformungen auftreten, welche die Rollenneigung der Druckplatten verursachen.

Zeitraubend ist bei den bekannten Geräten vor allem, dass die Freigabe der Druckplatte von der Vakuumplatte der jeweiligen Bearbeitungsstation eine bestimmte Zeit erfordert, da der Abbau des Unterdrucks der Vakuumplatte nicht schlagartig, sondern nur innerhalb eines bestimmten Zeitintervalls erfolgen kann.

Es kommt bei dem bekannten Gerät noch hinzu, dass die Transportvorrichtung für die Druckplatte von der Belichtungsstation zu dem Plattenmagazin zurückfahren muss, um eine weitere Druckplatte aus dem Magazin aufzunehmen und in die Belichtungsstation zu transportieren. Da bei den bekannten Geräten die einzelnen Stationen für die Belichtung, die Entwicklung, das Fixieren, Entschichten und eventuelle Stanzen der Druckplatte hintereinander aufgebaut sind, ist der Platzbedarf gross. Darüber hinaus sind zum Teil unterschiedliche Transportvorrichtungen, die beispielsweise mit Druckluft oder elektrischen Motoren arbeiten, für den Transport der Druckplatten von einer Bearbeitungsstation zur nächsten Bearbeitungsstation vorgesehen. Der Transport der Druckplatte zwischen den einzelnen Bearbeitungsstationen erhöht die Verarbeitungzeit der Druckplatten, und darüber hinaus vergrössert sich die Störanfälligkeit des Gerätes wegen des Einsatzes verschiedener Transportvorrichtungssysteme anstelle eines einzigen Transportsystems, das die Druckplatte zu den verschiedenen Bearbeitungsstationen befördern kann.

Aufgabe der Erfindung ist es, eine Saugvorrichtung für das Festhalten und die Beförderung eines Druckplattenverarbeitungsgeräts zu schaffen, die auch bei ungenügender Planlage der Druckplatte deren vollständiges Ansaugen auf der Vakuumplatte einer Bearbeitungsstation ermöglicht und die den Transport von Station zu Station ohne Wechsel der Transportvorrichtung ermöglicht. Darüber hinaus soll eine derartige Saugvorrichtung mit geringem Arbeitsaufwand auf verschiedene Plattengrössen umgerüstet werden können.

Diese Aufgabe wird erfindungsgemäss durch die im Anspruch 1 gekennzeichnete Saugvorrichtung gelöst.

Weitere Ausgestaltungen der Erfindung ergeben sich aus den Merkmalen der Ansprüche 2 bis 16.

Mit der Erfindung werden die Vorteile erzielt, dass die Druckplatte, auch wenn sie starke Rollenneigung besitzt, von der Mitte ausgehend nach aussen streifenweise von dem Saugtisch in eine Planlage angesaugt wird, dass die auf den einzelnen Saugtischen festgehaltenen Druckplatten gleichzeitig verschiedenen Bearbeitungsschritten unterzogen werden und dass eine kompakte Bauweise des Druckplattenverarbeitungsgerätes mit sehr kurzen Transportwegen und -zeiten von einer Bearbeitungsstation zur nachfolgenden Bearbeitungsstation erhalten wird. Des weiteren kann die Drehkreuzanordnung schnell und ohne grossen Aufwand auf ein neues Plattenformat umgerüstet werden und jede Druckplatte auf jedem Saugtisch durch Anschlagstifte in der gleichen Stellung positioniert werden.

Die Erfindung wird im folgenden anhand von zeichnerisch dargestellten Ausführungsbeispielen näher erläutert. Es zeigen:

Fig. 1 eine perspektivische Ansicht einer gerollten Druckplatte auf einem Saugtisch,

Fig. 2 eine erste Drehkreuzanordnung der Saugvorrichtung nach der Erfindung.

Fig. 3 einen Schnitt der Drehkreuzanordnung nach Fig. 2,

Fig. 4 eine aufgebrochene, teilweise geschnittene perspektivische Ansicht eines Saugtisches und eines Nabenteils nach Fig. 2,

Fig. 5 eine zweite Drehkreuzanordnung der Saugvorrichtung nach der Erfindung.

Fig. 6 im Detail eine Schnittansicht eines Flanschansatzes mit einem einzelnen angeflanschten Saugtisch,

Fig. 7 eine Unteransicht des Saugtisches nach Fig. 6, und

Fig. 8 eine perspektivische Ansicht eines Saugtisches mit Antriebsrollen, Anschlagstiften und Sensoren.

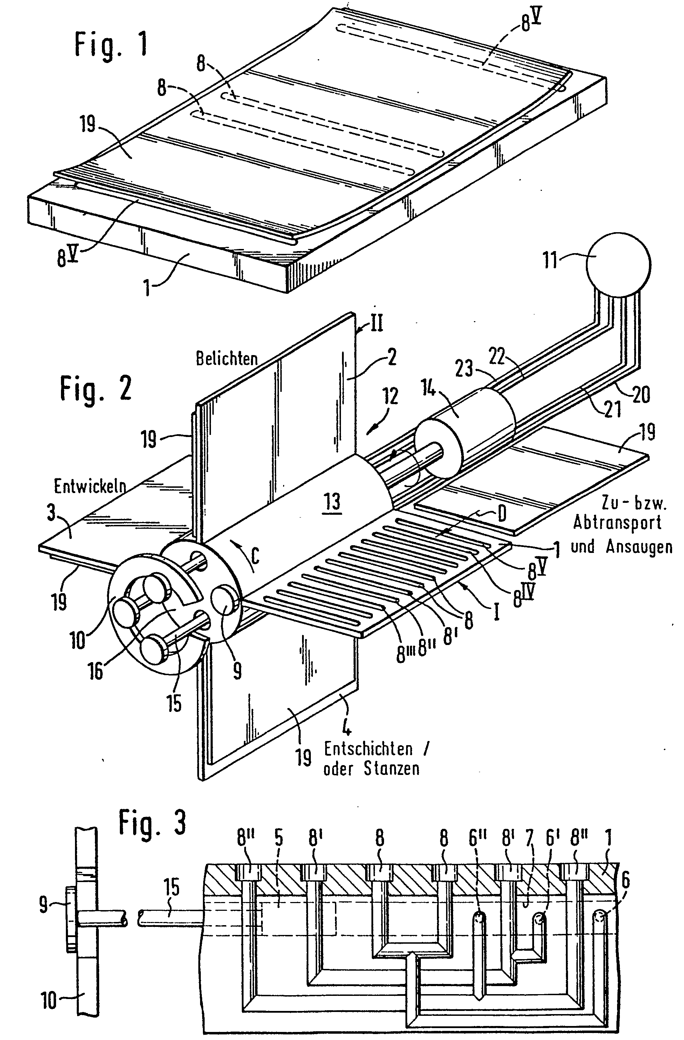

In Fig. 1 ist schematisch und perspektivisch eine Saugplatte eines Saugtisches 1 dargestellt, die in der Oberfläche Saugschlitze 8, 8; ...; 8$^V$, 8$^V$ aufweist. Es sind nur die beiden in der Mitte der Saugplatte befindlichen Saugschlitze 8, 8 gestrichelt dargestellt sowie die nahe den Rändern liegenden Saugschlitze 8$^V$, 8$^V$. Die dazwischen liegenden Saugschlitze sind aus Gründen der besseren Übersichtlichkeit weggelassen. Auf dem Saugtisch 1 liegt eine stark gerollte Druckplatte 19 auf, deren Seiten in der Nähe der Saugschlitze 8$^V$, 8$^V$ hochstehen. Sobald an die Saugschlitze 8, 8; ...; 8$^V$, 8$^V$ ein Unterdruck angelegt wird, kann sich durch die schlechte Abdeckung der Saugschlitze infolge der Rollenneigung der Druckplatte 19 zumindest nahe den Rändern der Druckplatte kein Unterdruck aufbauen, so dass die Druckplatte keineswegs eine Planlage auf dem Saugtisch 1 einnimmt. Es ist offensichtlich, dass bei mangelhafter Planlage das von einer Kopienvorlage auf die Druckplatte 19 projizierte Bild an den Rändern Verzerrungen erleidet, die dann auch in den Drucken aufscheinen, die mit einer derartigen Druckplatte hergestellt werden.

Das wesentliche Bauteil der in Fig. 2 gezeigten Saugvorrichtung ist eine Drehkreuzanordnung 12, die aus vier Saugtischen 1, 2, 3, 4 besteht, welche paarweise in zwei zueinander senkrechten Ebenen I, II liegen. Die Saugtische 1 und 3 liegen in der Ebene I und die Saugtische 2 und 4 in der Ebene II. Das Kernstück der Drehkreuzanordnung 12 ist ein zentraler Nabenteil 13, von dessen Umfangsfläche sich die einzelnen Saugtische nach aussen erstrecken.

Die Drehkreuzanordnung 12 wird von einem Motor 14 angetrieben, der die Drehkreuzanordnung 12 in Schritten von 90° verschwenkt.

In der Oberfläche jedes Saugtisches 1, 2, 3, 4 ist eine Anzahl von Saugschlitzen 8, 8; 8', 8'; ... ; 8$^V$, 8$^V$ vorhanden, die von der Mitte zu den Rändern des jeweiligen Saugtisches aufeinanderfolgend mit Unterdruck von einer Druckquelle 11 beaufschlagbar sind. Dabei werden in der Ober- bzw. Anlagefläche des einzelnen Saugtisches von der Mitte des Saugtisches ausgehend die Saugschlitze paarweise zu den Rändern zugeschaltet, wie nachstehend noch näher beschrieben werden wird. Hierdurch kommt es zu einem streifenweisen Ansaugen der auf dem Saugtisch aufliegenden Druckplatte 19 von der Mitte nach aussen.

Wie aus der Schnittdarstellung in Fig. 3 ersichtlich ist, sind die Saugschlitze 8, 8; 8', 8'; 8'', 8''; ... über Saugkanäle 6, 6', 6'', ... und eine Saugkammer 7 mit der Druckquelle 11 verbunden. Dabei sind die Saugschlitze in der Oberfläche des einzelnen Saugtisches 1, 2, 3, 4 paarweise derart zusammengeschlossen, dass die beiden mittleren Saugschlitze 8, 8 in der Anlagefläche miteinander kommunizieren und über den gemeinsamen Saugkanal 6 mit der Saugkammer 7 verbunden sind. Die rechts und links von den Saugschlitzen 8, 8 liegenden zwei Saugschlitze 8', 8' ebenso wie die daran angrenzenden beiden Saugschlitze 8'', 8'' und die übrigen daran anschliessenden Saugschlitze kommunizieren gleichfalls paarweise miteinander. Die Saugschlitze 8', 8' sind über den gemeinsamen Saugkanal 6' und die Saugschlitze 8'', 8'' über den gemeinsamen Saugkanal 6'' mit der Saugkammer 7 in Verbindung.

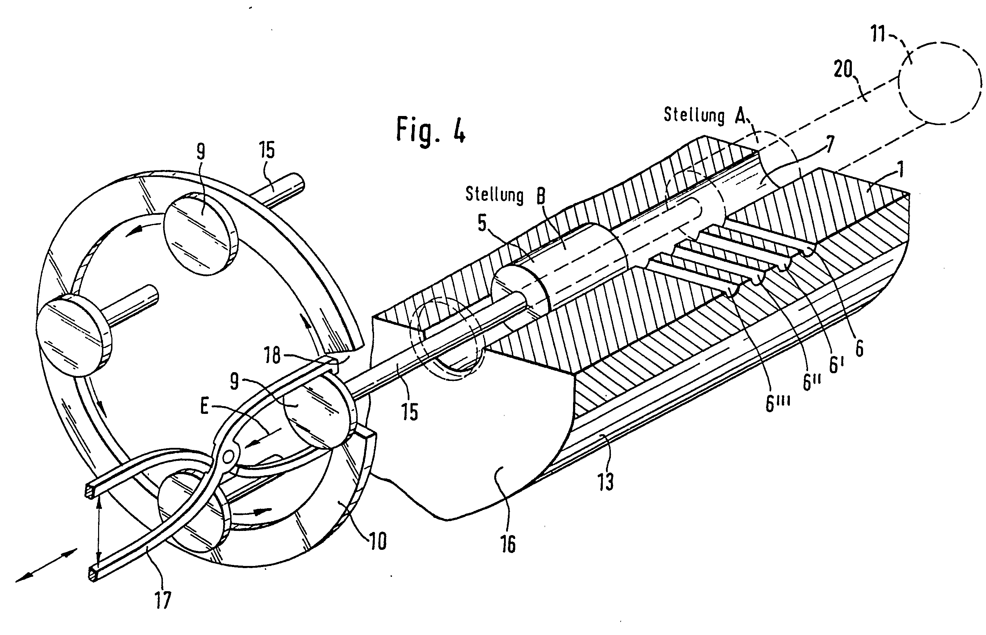

Im Nabenteil 13 sind vier derartige Saugkammern 7 vorgesehen, von denen jeweils eine einem bestimmten Saugtisch zugeordnet ist. Vier Druckleitungen 20 bis 23 verbinden die Saugkammern 7 mit der Druckquelle 11 (Fig. 2). Es ist in jedem Saugkanal 7 ein Kolben 5 vorgesehen, der von einer in Fig. 4 gezeigten Ausgangsstellung A in eine Endstellung B verschiebbar ist. Die Ausgangsstellung A des Kolbens 5 ist in Fig. 4 gestrichelt dargestellt, während seine Endstellung B mit festen Linien eingezeichnet ist. Jeder Kolben 5 trägt eine Kolbenstange 15, die aus einer Stirnfläche 16 des Nabenteils 13 herausgeführt ist, wobei diese Stirnfläche 16 weiter weg von der Druckquelle 11 liegt als die zweite Stirnfläche des Nabenteils 13 (s. Fig. 2).

Bei seiner Bewegung aus der Ausgangsstellung A in seine Endstellung B gibt der Kolben 5 zuerst den Saugkanal 6 der beiden mittleren Saugschlitze 8, 9 frei, anschliessend den Saugkanal 6' der an diese Saugschlitze links und rechts angrenzenden Saugschlitze 8', 8' und der Reihe nach die übrigen Saugkanäle 6'', 6'', ... , so dass von der Mitte der Anlagefläche des Saugtisches nach aussen hin die Saugkanäle der Reihe nach an die Saugkammer 7 angeschlossen werden, die mit der Unterdruck erzeugenden Druckquelle 11 verbunden ist. Dadurch wird in den Saugschlitzen, beginnend mit den beiden mittleren Saugschlitzen, der Reihe nach ein Vakuum aufgebaut, wodurch die Druckplatte 19 angesaugt wird und plan auf der Anlagefläche bzw. Oberfläche des Saugtisches aufliegt.

Sobald der Kolben 5 in der Saugkammer 7 des einzelnen Saugtisches 1, 2, 3 oder 4 seine Endstellung B erreicht hat, in der alle Saugkänale 6, 6', 6'', ... des betrachteten Saugtisches über die Saugkammer 7 an die Druckquelle 11 angeschlossen sind, schwenkt die Drehkreuzanordnung 12 um 90° in Richtung des Pfeils C in Fig. 2. Dadurch gelangen die Saugtische 1 und 3 aus der Horizontalebene I in die Vertikalebene II und umgekehrt die Saugtische 2 und 4 aus der Vertikalebene II in die Horizontalebene I. Während dieses Schwenkens um 90° bleiben die Druckplatten auf den Saugtischen angesaugt.

Wie aus Fig. 2 zu ersehen ist, befindet sich in einem Abstand von der Stirnfläche 16 eine Steuerkurvenscheibe 10, die beispielsweise als ein Kreisring mit einem Ausschnitt 18 ausgebildet sein kann. Diese Steuerkurvenscheibe 10 ist ortsfest angeordnet und kann im übrigen auch eine andere als die gezeigte Gestalt haben. Jede Kolbenstange 15 trägt an ihrem freien Ende eine Kreisscheibe 9, die in der Endstellung B des Kolbens 5 mit ihrer Innenseite teilweise gegen die Aussenseite und gegen den Innenrand der ortsfesten Steuerkurvenscheibe 10 anliegt. Der Abstand zwischen der Steuerkurvenscheibe 10 und der Stirnfläche 16 des Nabenteils 13 ist so gewählt, dass beim Anliegen der Innenseite der Kreisscheibe 9 gegen die Aussenseite der Steuerkurvenscheibe 10 die Kolben 5 sämtliche Saugkanäle 6, 6', 6'', ... freigeben, so dass diese über die Saugkammern 7 mit der Druckquelle 11 verbunden und von dieser mit Unterdruck beaufschlagt werden.

In Fig. 4 ist entsprechend die Stellung des Kolbens 5 und das Anliegen der Innenseite der Kreisscheibe 9 an der Steuerkurvenscheibe 10 dargestellt. Die Fig. 4 zeigt im teilweisen Schnitt nur die Saugkanäle 6, 6', ... sowie den Kolben 5 und die Saugkammer 7 für einen einzigen Saugtisch. Aus Gründen der besseren Übersichtlichkeit wurden die übrigen drei Saugtische mit ihren Saugkanälen und Saugkammern sowie Kolben in Fig. 4 weggelassen und nur durch die Kolbenstangen und die Kreisscheiben ihr Vorhandensein angedeutet.

Das Verschieben des Kolbens 5 aus seiner Ausgangsstellung A in seine Endstellung B erfolgt mit Hilfe einer Greifereinrichtung 17, die durch den Ausschnitt 18 der ortsfesten Steuerkurvenscheibe 10 hindurch die Kreisscheibe 9 der Kolbenstange 15 erfasst und in Richtung des Pfeils E zieht. Sobald der Kolben 5 seine Endstellung B erreicht hat, erfolgt ein Verschwenken der Drehkreuzanordnung 12 und damit auch der durch den Ausschnitt 18 hindurchgezogenen Kolbenstange 15 um 90°, so dass die Kreisscheibe 9 dieser Kolbenstange auf der Aussenseite der Steuerkurvenscheibe 10 zu liegen kommt. Dadurch ist gewährleistet, dass der Kolben 5 durch das in der Saugkammer 7 bestehende Vakuum nicht in seine Ausgangsstellung A zurückkehren kann, da die Steuerkurve 10 eine Bewegung entgegengesetzt zu der Bewegung in Richtung des Pfeils E blockiert.

Die Arbeitsweise der Saugvorrichtung ist folgende:

Bei der in Fig. 2 gezeigten Stellung der Drehkreuzanordnung 12 wird beispielsweise eine Druckplatte 19 in Richtung des Pfeils D auf den Saugtisch 1 transportiert. Sobald die Druckplatte 19 auf der Anlagefläche des Saugtisches 1 positioniert ist, erfolgt das Ansaugen in der vorstehend beschriebenen Weise, indem die Greifereinrichtung 17 die Kreisscheibe 9 erfasst und den Kolben 5 aus seiner Ausgangsstellung A in seine Endstellung B zieht. Das Ansaugen der Druckplatte 19 ist dann beendet und die Drehkreuzanordnung 12 wird durch den Motor 14, der entsprechend gesteuert wird, um 90° verschwenkt, so dass der Saugtisch 1 mit der Druckplatte 19 eine vertikale Lage in der Ebene II einnimmt. In dieser Lage erfolgt die Belichtung der Druckplatte 19 durch nicht gezeigte Belichtungseinrichtungen. Bei dem Verschwenken um 90° gelangt der Saugtisch 4 aus der Vertikalebene II in die Horizontalebene I und nimmt die Lage des nunmehr hochgeschwenkten Saugtisches 1 ein. Während des Hochschwenkens des Saugtisches 4 gleitet die Kreisscheibe 9 der Kolbenstange 15 des zugehörigen Kolbens an der Innenseite der Steuerkurvenscheibe 10 entlang, bis sie den Ausschnitt 18 erreicht hat. Da der Saugtisch 4 mit Unterdruck beaufschlagt ist, wird der Kolben 5, sobald seine Kreisscheibe 9 den Ausschnitt 18 erreicht hat, durch den Unterdruck in eine Richtung entgegengesetzt zur Richtung des Pfeils E angesaugt, so dass die Kreisscheibe 9 gegen die Stirnfläche 16 des Nabenteils 13 zu liegen kommt, wie dies in Fig. 2 dargestellt ist. Durch diesen schlagartigen Abbau des Vakuums in der Saugkammer 7 wird die auf dem Saugtisch 4 befindliche Druckplatte 19 freigegeben und kann in Richtung des Pfeils D abtransportiert werden. Auf den Saugtisch 4 wird dann eine neue Druckplatte 19 in Richtung D geschoben. Die Greifereinrichtung 17 erfasst anschliessend die Kreisscheibe 9 und zieht sie bis auf die Höhe der Steuerkurvenscheibe 10 in Richtung des Pfeils E. Dadurch wird die neu aufgebrachte Druckplatte 19 auf dem Saugtisch 4 angesaugt. Sobald dieser Vorgang abgeschlossen ist, schwenkt der Motor 14 die Drehkreuzanordnung 12 neuerlich um 90° in Richtung des Pfeils C. Der Saugtisch 1 befindet sich dann in der Horizontalebene I, wobei die angesaugte Druckplatte 19 nach unten zeigt. In dieser Position der Drehkreuzanordnung 12 wird die Druckplatte 19 auf dem Saugtisch 1 mittels nicht gezeigter Einrichtungen entwickelt, während die Druckplatte 19 auf dem Saugtisch 4, der sich in der Vertikalebene II befindet, belichtet wird und von dem Saugtisch 3 eine fertige Druckplatte transportiert und eine neue Druckplatte 19 angesaugt wird. Danach erfolgt eine weitere Verschwenkung der Drehkreuzanordnung 12 um 90°, so dass der Saugtisch 1 in der Vertikalebene II zu liegen kommt, in der die Druckplatte 19 beispielsweise gestanzt oder entschichtet wird. Mit der nächsten Verschwenkung der Drehkreuzanordnung 12 um 90° gelangt der Saugtisch 1 in seine Ausgangslage zurück, in der das Vakuum schlagartig aufgehoben wird, so dass die Druckplatte 19 freigegeben und in Richtung des Pfeils D abtransportiert werden kann. Eine weitere Druckplatte 19 wird auf den Saugtisch 1 geschoben und der Verarbeitungszyklus beginnt von neuem.

Mit der Saugvorrichtung können somit vier Druckplatten gleichzeitig verarbeitet werden, von denen jede einzelne Druckplatte einen anderen Verfahrensschritt als die übrigen drei Druckplatten nach jeder 90°-Schwenkung der Drehkreuzanordnung 12 durchläuft. Es ist offensichtlich, dass dadurch eine grosse Zeitersparnis bei der Verarbeitung einer grösseren Anzahl von Druckplatten erzielt wird. Selbstverständlich kann der Bearbeitungszyklus auch aus anderen Bearbeitungsschritten als den beschriebenen Schritten bestehen.

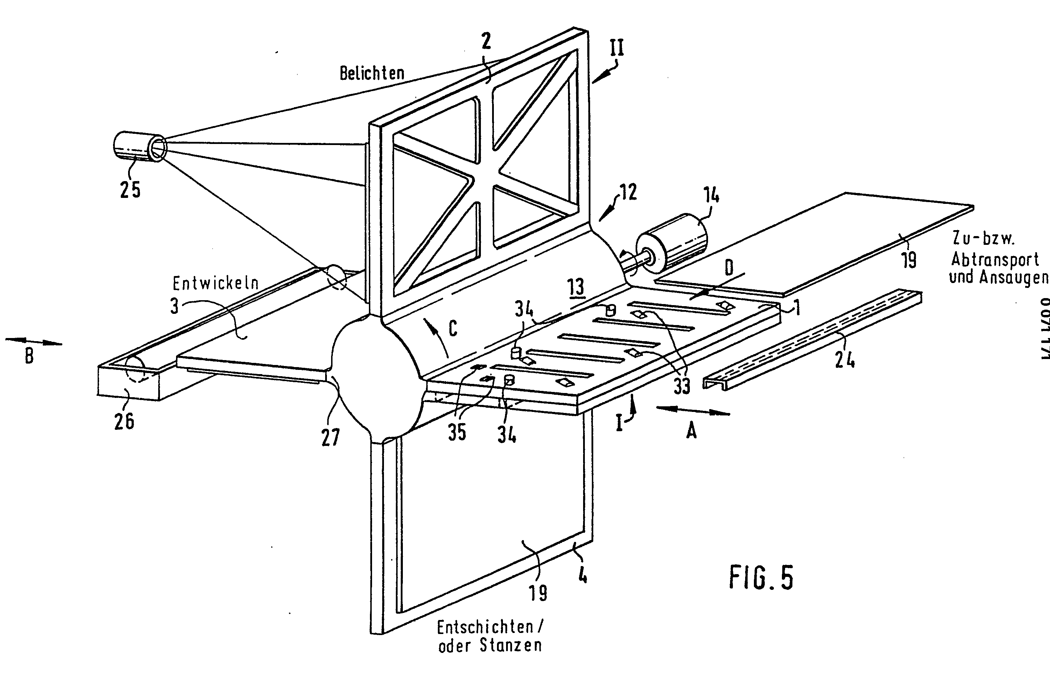

Bei der in Fig. 5 dargestellten weiteren Ausführungsform der Erfindung weist das Nabenteil 13 Flanschansätze 27 auf, an denen die Saugtische 1 bis 4 angeflanscht sind. Diese Flanschansätze 27 erstrecken sich in radialer Richtung von der Umfangsfläche des zylindrischen Nabenteils 13 und verlaufen beispielsweise parallel zur Nabenachse über die Gesamtlänge des Nabenteils. Es ist auch möglich, dass die Flanschansätze 27 kürzer ausgebildet sind und sich nur jeweils nahe den beiden Stirnflächen des Nabenteils 13 erstrecken.

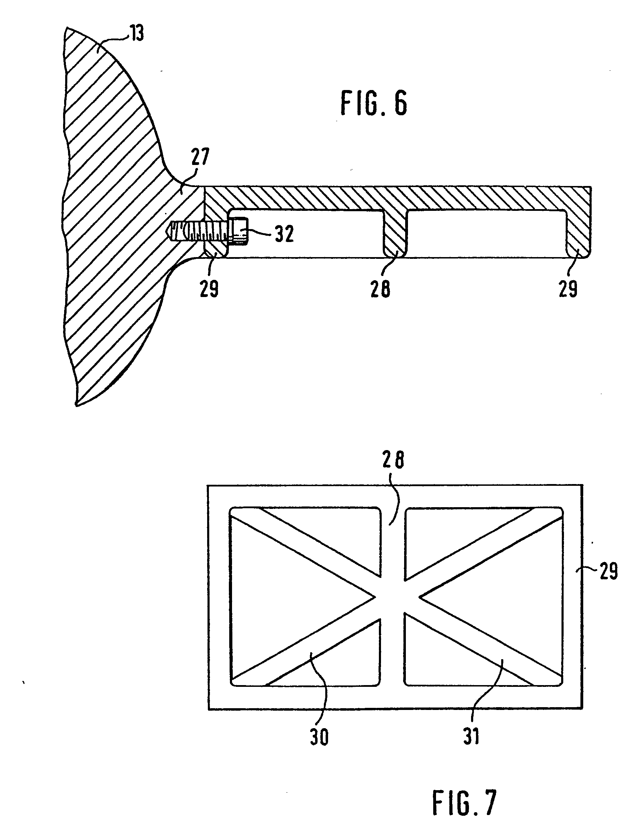

Der einzelne Saugtisch 1 bis 4 (vgl. Fig. 7) weist auf seiner Unterseite einen umlaufenden Flansch 29 und einen mittig angeordneten Steg 28 auf. Der Flansch 29 ist zugleich ein Rand des Saugtisches und dient zusammen mit dem Steg 28 sowie diagonalen Querstreben 30 und 31 der Versteifung des Saugtisches. In demjenigen Abschnitt des Flansches 29, der an das Nabenteil 13 angeflanscht wird, sind Löcher vorhanden, die mit entsprechenden Löchern in dem Flanschansatz 27 des Nabenteils 13 fluchten. Diese Löcher weisen Innengewinde auf, die ein Verschrauben des Saugtisches mit dem Flanschansatz 27 des Nabenteils 13 mittels Schrauben 32 ermöglichen.

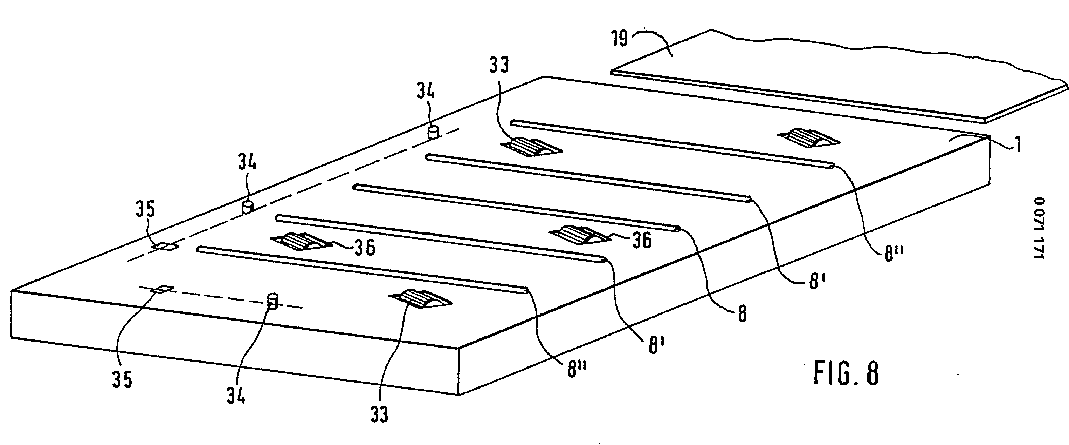

Wie aus Fig. 8 zu ersehen ist, ist jeder Saugtisch 1 bis 4 mit zur Transportrichtung der Druckplatte 19 schräggestellten Antriebsrollen 33 ausgerüstet, die in Öffnungen 36 in der Auflageebene des Saugtisches angeordnet sind. Diese Antriebsrollen 33 sind in Fig. 5 unter das Niveau der Auflageebene des Saugtisches 1 abgesenkt und werden, sobald die Druckplatte 19 mit ihrer Vorderkante auf den Saugtisch 1 gelangt, über das Niveau der Auflageebene angehoben, um den Transport der Druckplatte 19 auf der Auflageebene zu bewerkstelligen. Nahe der einen Längskante des Saugtisches 1 sind Anschlagstifte 34 angeordnet, die gleichfalls in den Saugtisch 1 versenkbar und aus diesem ausfahrbar sind. Sobald die Druckplatte 19 auf den Saugtisch 1 gelangt, sind die Anschlagstifte 34 ausgefahren. Ein weiterer Anschlagstift 34 ist nahe der quer zur Transportrichtung verlaufenden Kante des Saugtisches 1 vorgesehen. Es ist selbstverständlich, dass in Längsrichtung bzw. in Transportrichtung der Druckplatte 19 mehr als zwei Anschlagstifte und in Querrichtung zur Transportrichtung auch zwei oder mehrere Anschlagstifte 34 vorhanden sein können. Die Antriebsrollen 33 bewegen die Druckplatten 19 bis zum Anliegen an die ausgefahrenen Anschlagstifte 34. Liegen die Plattenkanten an den ausgefahrenen Anschlagstiften 34 an, so werden sie von Sensoren 35 erfasst, die den Antrieb der Antriebsrollen 33 abschalten, die Anschlagstifte 34 und die Antriebsrollen 33 absenken und das Vakuum für den Saugtisch 1 einschalten, so dass die Druckplatte über die Saugschlitze 8, 8', 8'', ... angesaugt wird. Die Sensoren 35 sind derart angeordnet, dass ihre Mittellinie, die in Fig. 8 gestrichelt eingezeichnet ist, in etwa die Tangente an die Innenseiten der Anschlagstifte 34 bildet.

Bei der in Fig. 5 gezeigten Stellung der Drehkreuzanordnung 12 wird beispielsweise die Druckplatte 19 in Richtung des Pfeils D auf den Saugtisch 1 transportiert. Sobald die Druckplatte 19 auf der Auflageebene des Saugtisches 1 durch die Anschlagstifte 34 im Zusammenwirken mit den Antriebsrollen 33 positioniert ist, erfolgt das Ansaugen der Druckplatte. Nach Beendigung des Ansaugvorganges erfolgt das elektrostatische Aufladen der Druckplatte 19 durch eine Coronavorrichtung 24, die in den Richtungen des Doppelpfeils A über die Druckplatte 19 verfahren wird. Sobald die Coronavorrichtung 24 wieder in ihre Ausgangsstellung zurückgekehrt ist, wird die Drehkreuzanordnung 12 durch den Motor 14, der entsprechend gesteuert wird, um 90° verschwenkt, so dass der Saugtisch 1 mit der Druckplatte 19 eine Vertikallage in der Ebene II einnimmt. In dieser Lage erfolgt die Belichtung der Druckplatte 19 durch eine Lichtquelle 25, die beispielsweise ein nicht gezeigtes Transparentoriginal durchstrahlt und auf die aufgeladene Druckplatte 19 projiziert.

Die Positionierung erfolgt bei der Ausführungsform nach Fig. 1 in gleicher Weise.

Da mit der Saugvorrichtung vier Druckplatten gleichzeitig verarbeitet werden, von denen jede einzelne Druckplatte einen anderen Verfahrensschritt als die übrigen drei Druckplatten nach jeder 90°-Schwenkung der Drehkreuzanordnung 12 durchläuft, ist es offensichtlich, dass eine genaue Positionierung jeder einzelnen Druckplatte 19 jeweils an der gleichen Stelle erforderlich ist, um eine gleichbleibende Qualität der belichteten und entwickelten Druckplatten zu gewährleisten. Durch die Möglichkeit, die Abmessungen der Saugtische entsprechend den Formaten der zu verarbeitenden Druckplatten auszuwählen und ohne grossen Aufwand an das Nabenteil anzuflanschen, ergibt sich eine hohe Flexibilität und ein breiter Einsatzbereich der Saugvorrichtung.

## Patentansprüche

1. Saugvorrichtung zum Festhalten von Druckplatten in einer Bearbeitungsposition durch Unterdruck und zum Transport durch mehrere Bearbeitungsstationen, dadurch gekennzeichnet, dass eine Drehkreuzanordnung (12) aus mehreren Saugtischen (1, 2, 3, ...) die Saugvorrichtung bildet, dass in der Oberfläche jedes Saugtisches eine Anzahl von Saugschlitzen (8, 8; 8', 8'; 8'', 8''; ...) vorhanden ist, die über Saugkanäle (6, 6', 6'', 6''',

...) und eine Saugkammer (7) mit einer Druckquelle (11) verbunden sind, und dass die Saugschlitze (8, 8; 8', 8'; 8'', 8''; ...; 8ᵛ, 8ᵛ) von der Mitte zu den Rändern des Saugtisches aufeinanderfolgend mit Unterdruck von der Druckquelle (11) beaufschlagbar sind.

2. Saugvorrichtung nach Anspruch 1, dadurch gekennzeichnet, dass die Drehkreuzanordnung (12) aus vier Saugtischen (1, 2, 3, 4) besteht, die paarweise (1, 3; 2, 4) in zwei zueinander senkrechten Ebenen (I, II) liegen und sich vom Umfang eines zentralen Nabenteils (13) nach aussen erstrecken.

3. Saugvorrichtung nach Anspruch 1, dadurch gekennzeichnet, dass die Saugschlitze in der Oberfläche des einzelnen Saugtisches (1, 2, 3, 4) paarweise derart miteinander verbunden sind, dass die beiden mittleren Saugschlitze (8, 8), die an diese links und rechts anschliessenden zwei Saugschlitze (8', 8'), die daran angrenzenden beiden Saugschlitze (8'', 8'') sowie die dazu benachbarten Saugschlitze (8''', 8''') und die übrigen daran anschliessenden Saugschlitze miteinander kommunizieren.

4. Saugvorrichtung nach Anspruch 3, dadurch gekennzeichnet, dass jedes Paar von kommunizierenden Saugschlitzen (8, 8; 8', 8'; 8'', 8'') über einen gemeinsamen Saugkanal (6, 6', 6'', 6''') mit der dazugehörigen Saugkammer (7) im Nabenteil (13) verbunden ist und dass in jeder Saugkammer (7) ein Kolben (5) von einer Ausgangsstellung (A) in eine Endstellung (B) verschiebbar ist.

5. Saugvorrichtung nach Anspruch 4, dadurch gekennzeichnet, dass der Kolben (5) zuerst den Saugkanal (6) der beiden mittleren Saugschlitze (8, 8), anschliessend den Saugkanal (6') der an diese Saugschlitze links und rechts angrenzenden Saugschlitze (8', 8') und der Reihe nach die übrigen Saugkanäle (6'', 6'') für den Anschluss an die Unterdruck erzeugende Druckquelle (11) über die Saugkammer (7) freigibt.

6. Saugvorrichtung nach Anspruch 1, dadurch gekennzeichnet, dass die Drehkreuzanordnung (12) mit einem Motor (14) verbunden ist, der die Drehkreuzanordnung (12) jeweils um 90° schwenkt, sobald der Kolben (5) in der Saugkammer (7) des einzelnen Saugtisches (1, 2, 3, 4) seine Endstellung (B) erreicht hat, in der alle Saugkanäle (6, 6', ...) des einzelnen Saugtisches über die Saugkammer (7) an die Druckquelle (11) angeschlossen sind.

7. Saugvorrichtung nach Anspruch 4, dadurch gekennzeichnet, dass jeder Kolben (5) eine Kolbenstange (15) aufweist, die aus derjenigen Stirnfläche (16) des Nabenteils (13) herausgeführt ist, die weiter weg von der Druckquelle (11) liegt.

8. Saugvorrichtung nach Anspruch 7, dadurch gekennzeichnet, das jede Kolbenstange (15) an ihrem freien Ende eine Kreisscheibe (9) trägt, die mit ihrer Innenseite teilweise gegen die Aussenseite und den Innenrand einer ortsfesten Steuerkurvenscheibe (10) über den grössten Teil deren Umfangs während des Schwenkens der Drehkreuzanordnung (12) anliegt.

9. Saugvorrichtung nach Anspruch 8, dadurch gekennzeichnet, dass eine Greifereinrichtung (17) vorhanden ist, welche die Kreisscheibe (9) erfasst und den Kolben (5) von seiner Ausgangsstellung (A) in seine Endstellung (B) bewegt.

10. Saugvorrichtung nach Anspruch 9, dadurch gekennzeichnet, dass die ortsfeste Steuerkurvenscheibe (10) einen Ausschnitt (18) aufweist, durch den hindurch die Greifereinrichtung (17) die Kreisscheibe (9) der Kolbenstange (15) erfasst.

11. Saugvorrichtung nach Anspruch 1, dadurch gekennzeichnet, dass die Drehkreuzanordnung (12) aus vier Saugtischen (1, 2, 3, 4) besteht, die an einem zylindrischen Nabenteil (13) auswechselbar angeflanscht sind, und dass die Abmessungen der Saugtische (1, 2, 3, 4) entsprechend dem Format der zu verarbeitenden Platten (19) auswählbar sind.

12. Saugvorrichtung nach Anspruch 11, dadurch gekennzeichnet, dass an dem Nabenteil (13) Flanschansätze (27) vorhanden sind und dass das Nabenteil (13) mit einem Schrittmotor (14) verbunden ist, der die Drehkreuzanordnung (12) in 90°-Schritten verschwenkt.

13. Saugvorrichtung nach Anspruch 1, dadurch gekennzeichnet, dass jeder Saugtisch (1, 2, 3, 4) mit zur Transportrichtung der Platte (19) schräggestellten Antriebsrollen (33) für den Transport der Platte (19) auf dem Saugtisch ausgerüstet ist.

14. Saugvorrichtung nach Anspruch 13, dadurch gekennzeichnet, dass die Antriebsrollen (33) über das Niveau der Auflageebene des Saugtisches (1, 2, 3, 4) anhebbar und darunter absenkbar sind.

15. Saugvorrichtung nach Anspruch 14, dadurch gekennzeichnet, dass in Transportrichtung der Platte (19) nahe der einen Längskante des Saugtisches (1, 2, 3, 4) und quer zur Transportrichtung Anschlagstifte (34) angeordnet sind, die in den Saugtisch (1, 2, 3, 4) versenkbar und aus diesem ausfahrbar sind.

16. Saugvorrichtung nach Anspruch 15, dadurch gekennzeichnet, dass Sensoren (35) in der Auflageebene des Saugtisches die an den ausgefahrenen Anschlagstiften (34) anliegenden Plattenkanten erfassen, den Antrieb der Antriebsrollen (33) abschalten und die Anschlagstifte (34) und die Antriebsrollen (33) absenken.

## Claims

1. A suction device for securely holding printing plates in a processing position, by sub-atmospheric pressure, and for transporting them through a plurality of processing stations, characterized in that this suction device comprises a turnstile arrangement (12) which is formed by a plurality of suction tables (1, 2, 3, ...), in that a number of suction slots (8, 8; 8', 8',; 8'', 8''; ...) are provided in the surface of each suction table, these slots being connected, *via* suction passages (6, 6', 6'', 6''', ...) and a suction chamber (7), to a pressure source (11), and in that a sub-atmospheric pressure from the pressure source (11) can be applied to the suction slots (8, 8; 8', 8'; 8'', 8''; ...; $8^V$, $8^V$), successively from the center of the suction table to its edges.

2. The suction device as claimed in Claim 1, characterized in that the turnstile arrangement (12) comprises four suction tables (1, 2, 3, 4), which are located, in pairs (1, 3; 2, 4), in two mutually perpendicular planes (I, II), and which extend outwards from the periphery of a central hub part (13).

3. The suction device as claimed in Claim 1, characterized in that the suction slots in the surface of the individual suction table (1, 2, 3, 4) are connected, one to another, in pairs, in a manner such that the two central, suction slots (8, 8), the two suction slots (8', 8') which are adjacent to these slots on the left and on the right, the two suction slots (8'', 8'') which are adjacent thereto, and the suction slots (8''', 8''') which are adjacent to the slots (8'', 8''), and the remaining suction slots, adjacent thereto, communicate with each other.

4. The suction device as claimed in Claim 3, characterized in that each pair of communicating suction slots (8, 8; 8', 8'; 8'', 8'') is connected, *via* a common suction passage (6, 6', 6'', 6'''), to the associated suction chamber (7) in the hub part (13), and in that a piston (5) can be shifted, in each suction chamber (7), from a starting position (A) into an end position (B).

5. The suction device as claimed in Claim 4, characterized in that the piston (5) first of all opens the suction passage (6) of the two central suction slots (8, 8), then opens the suction passage (6') of the suction slots (8', 8'), which are adjacent to these suction slots, on the left and on the right, and successively opens the remaining suction passages (6'', 6'') for the connection, *via* the suction chamber (7), to the pressure source (11) which generates the sub-atmospheric pressure.

6. The suction device as claimed in Claim 1, characterized in that the turnstile arrangement (12) is connected to a motor (14), which rotates the turnstile arrangement (12), through 90°, whenever the piston (5) in the suction chamber (7) of the individual suction table (1, 2, 3, 4) has reached its end position (B), in which all suction passages (6, 6', ...) of the individual suction table are connected, *via* the suction chamber (7), to the pressure source (11).

7. The suction device as claimed in Claim 4, wherein each piston (5) has a piston rod (15), which is led out of that end face (16) of the hub part (13), which is located further away from the pressure source (11).

8. The suction device as claimed in Claim 7, characterized in that each piston rod (15) carries, at its free end, a circular plate (9), the inner surface of this plate bearing partly against the outside and the inner edge of a stationary radial cam-plate (10), over the greatest portion of its periphery, during the rotary movement of the turnstile arrangement (12).

9. The suction device as claimed in Claim 8, characterized in that a gripping device (17) exists, which grips the circular plate (9) and moves the piston (5) from its starting position (A) into its end position (B).

10. The suction device as claimed in Claim 9, characterized in that the stationary radial cam-plate (10) posesses a cut-out (18), through which the gripping device (17) grips the circular plate (9) of the piston rod (15).

11. The suction device as claimed in Claim 1, characterized in that the turnstile arrangement (12) comprises four suction tables (1, 2, 3, 4), which are flanged onto a cylindrical hub part (13), in a manner permitting their replacement, and in that the dimensions of the suction tables (1, 2, 3, 4) can be selected to correspond with the format of the plates (19) which are to be processed.

12. The suction device as claimed in Claim 11, characterized in that flange extensions (27) exist on the hub part (13), and in that the hub part (13) is connected to a stepping motor (14), which rotates the turnstile arrangement (12) in 90°-steps.

13. The suction device as claimed in Claim 11, characterized in that each suction table (1, 2, 3, 4) is equipped with drive rollers (33) for transporting the plate (19) on the suction table, these rollers (33) being set obliquely to the transport direction of the plate (19).

14. The suction device as claimed in Claim 13, characterized in that the drive rollers (33) can be raised above the level of the supporting plane of the suction table (1, 2, 3, 4), and can be lowered beneath this plane.

15. The suction device as claimed in Claim 14, characterized in that stop-pins (34) are arranged in the transport direction of the plate (19), near one longitudinal edge of the suction table (1, 2, 3, 4), and transversal to the transport direction, these stop-pins being capable of being lowered into the suction table (1, 2, 3, 4), and of being extended from this table.

16. The suction device as claimed in Claim 15, characterized in that the edges of the plate, which bear against the extended stop-pins (34), are detected by sensors (35) in the supporting plane of the suction table, these sensors switching-off the drive to the drive rollers (33), and lowering the stop-pins (34) and the drive rollers (33).

**Revendications**

1. Dispositif d'aspiration destiné à immobiliser des plaques d'impression dans une position de traitement par dépression et à les transporter à travers plusieurs postes de travail, caractérisé en ce qu'un tourniquet (12) composé de plusieurs tables aspirantes (1, 2, 3, ...) forme le dispositif d'aspiration, en ce que, dans la surface de chaque table aspirante, se trouve un certain nombre de fentes d'aspiration (8, 8; 8', 8'; 8'', 8''; ...) qui sont reliées à une source de pression (11) par l'intermédiaire de conduits d'aspiration (6, 6', 6'', 6''', ...) et d'une chambre d'aspiration (7), et en ce que les fentes d'aspiration (8, 8; 8′, 8′; 8″, 8″; ...; 8ᵛ, 8ᵛ) peuvent être sollicitées en dépression par la source de pression (11) les unes à la suite des autres, du milieu vers les bords de la table aspirante.

2. Dispositif d'aspiration selon la revendication 1, caractérisé en ce que le tourniquet (12) est composé de quatre tables aspirantes (1, 2, 3, 4) qui sont disposées par paires (1, 3; 2, 4) dans deux plans (I, II) perpendiculaires entre eux et font saillie vers l'extérieur sur la périphérie d'une partie-moyeu centrale (13).

3. Dispositif d'aspiration selon la revendication 1, caractérisé en ce que les fentes d'aspiration de la surface de chaque table aspirante (1, 2, 3, 4) sont reliées entre elles par paires de telle manière que les deux fentes d'aspiration centrales (8, 8), les deux fentes d'aspiration (8′, 8′) qui font suite à celles-ci à droite et à gauche, les deux fentes d'aspiration (8′, 8″) qui leur sont adjacentes ainsi que les deux fentes d'aspiration (8‴, 8‴) adjacentes à celles-ci, de même que les autres fentes d'aspiration qui leur font suite, communiquent entre elles.

4. Dispositif d'aspiration selon la revendication 3, caractérisé en ce que chaque paire de fentes d'aspiration communicantes (8, 8; 8′, 8′; 8″, 8″) est reliée, par l'itermédiaire d'un conduit d'aspiration commun (6, 6′, 6″, 6‴), à la chambre d'aspiration (7) correspondante située dans la partie-moyeu (13) et en ce que, dans chaque chambre d'aspiration (7), un piston (5) peut coulisser d'une position de départ (A) à une position finale (B).

5. Dispositif d'aspiration selon la revendication 4, caractérisé en ce que le piston (5) démasque tout d'abord le conduit d'aspiration (6) des deux fentes d'aspiration centrales (8, 8), puis le conduit d'aspiration (6′) des fentes d'aspiration (8′, 8′) qui sont adjacentes à ces fentes d'aspiration, à droite et à gauiche, et, ensuite et successivement, les autres conduits d'aspiration (6″, 6″), pour le raccordement à la source de pression (11) qui produit la dépression, par l'intermédiaire de la chambre d'aspiration (7).

6. Dispositif d'aspiration selon la revendication 1, caractérisé en ce que le tourniquet (12) est relié à un moteur (14) qui le fait tourner de 90° à chaque fois, dès que le piston (5) a atteint, dans la chambre d'aspiration (7) de la table aspirante considérée (1, 2, 3, 4), sa position finale (B) dans laquelle tous les conduits d'aspiration (6, 6′, ...) de la table d'aspiration considérée par l'intermédiaire de la chambre d'aspiration (7) sont raccordés à la source de pression (11).

7. Dispositif d'aspiration selon la revendication 4, caractérisé en ce que chaque piston (5) possède une tige de piston (15) qui émerge de la surface frontale (16) de la partie-moyeu (13) qui est la plus éloignée de la source de pression (11).

8. Dispositif d'aspiration selon la revendication 7, caractérisé en ce que chaque tige de piston (15) porte, à son extrémité libre, un disque circulaire (9) qui est appliqué partiellement par sa face interne contre la face externe et le bord intérieur d'une came de commande (10) fixe en position sur la plus grande partie de sa circonférence pendant la rotation du tourniquet (12).

9. Dispositif d'aspiration selon la revendication 8, caractérisé en ce qu'il est prévu un dispositif à pince (17) qui saisit le disque circulaire (9) et amène le piston (5) de sa position de départ (A) à sa position finale (B).

10. Dispositif d'aspiration selon la revendication 9, caractérisé en ce que la came de commande fixe (10) présente une coupure (18) à travers laquelle le dispositif à pince (17) saisit le disque circulaire (9) de la tige de piston (15).

11. Dispositif d'aspiration selon la revendication 1, caractérisé en ce que le tourniquet (12) est composé de quatre tables aspirantes (1, 2, 3, 4) qui sont montées de façon interchangeable sur une partie-moyeu cylindrique (13) et en ce que les dimensions des tables aspirantes (1, 2, 3, 4) peuvent être choisies en fonction du format des plaques (19) à traiter.

12. Dispositif d'aspiration selon la revendication 11, caractérisé en ce que, sur la partie-moyeu (13), sont situés des bossages de montage (27) et en ce que la partie-moyeu (13) est reliée à un moteur pas à pas (14) qui fait tourner le tourniquet (12) par pas de 90°.

13. Dispositif d'aspiration selon la revendication 11, caractérisé en ce que chaque table aspirante (1, 2, 3, 4) est équipée de rouleaux d'entraînement (33) disposés obliquement à la direction de transport de la plaque (19), pour assurer le transport de la plaque (19) sur la table aspirante.

14. Dispositif d'aspiration selon la revendication 13, caractérisé en ce que les rouleaux d'entraînement (33) peuvent être relevés au-dessus du niveau du plan d'appui de la table aspirante (1, 2, 3, 4) et abaissés au-dessous de ce niveau.

15. Dispositif d'aspiration selon la revendication 14, caractérisé en ce qu'à proximité de l'un des bords longitudinaux de la table aspirante (1, 2, 3, 4), dans le sens du transport de la plaque ainsi que transversalement à la direction du transport, sont disposés des doigts de butée (34) qui peuvent être abaissés dans la table aspirante (1, 2, 3, 4) et mis en extension à l'extérieur de celle-ci.

16. Dispositif d'aspiration selon la revendication 15, caractérisé en ce que des capteurs (35), placés dans le plan d'appui de la table aspirante, détectent les bords des plaques qui sont appuyées contre les doigts de butée (34) mis en extension, mettent à l'arrêt l'entraînement des rouleaux d'entraînement (33) et rétractent les doigts de butée (34) et les rouleaux d'entraînement (33).

0 071 171

Fig. 1

Fig. 2

Belichten

Entwickeln

Zu- bzw.
Abtransport
und Ansaugen

Entschichten /
oder Stanzen

Fig. 3

# Fig. 4

Stellung A

Stellung B

0071171

Belichten

Entwickeln

Zu- bzw.
Abtransport
und Ansaugen

Entschichten/
oder Stanzen

FIG.5

0 071 171

FIG. 6

27

32

29       28       29

13

28

29

30     31

FIG. 7

FIG. 8

0 071 171